# EUROPEAN PATENT SPECIFICATION

(11) **EP 1 781 074 B1**
(45) Date of publication and mention of the grant of the patent: **03.10.2012**
(21) Application number: 06123283.1
(22) Date of filing: 31.10.2006
(51) Int. Cl.: B25F 5/00, H01M 2/34, H05K 7/20

(54) **Diode assembly for a cordless power tool**
Diode-Anordnung für ein schnurloses elektrisches Werkzeug
Assemblage de diode pour un outillage électrique sans fil

(30) Priority: 01.11.2005 US 731854 P
(43) Date of publication of application: 02.05.2007
(73) Proprietor: Black & Decker, Inc., Newark, DE 19711 (US)
(72) Inventor: Opsitos Jr, Robert J., Felton, PA 17322 (US)
(74) Representative: Bell, Ian Stephen

(56) References cited:
- EP-A- 0 512 316
- US-A1- 2001 053 313
- US-A1- 2002 172 035
- US-A1- 2005 221 659
- US-B1- 6 749 028

## Description

Example embodiments relate generally to diodes in a wire harness for cordless power tools.

Cordless products which use rechargeable batteries are prevalent throughout the workplace as well as in the home. From house wares to power tools, rechargeable batteries are used in numerous devices. Ordinarily, nickel-cadmium (NiCd), nickel metal hydride (NiMH) and/or Lithium-ion (Li-ion) battery cells are used in these devices.

Various battery technologies can be damaged when discharged in excess of the manufacturer's recommendations. Accordingly, in order to protect the battery pack, circuitry to prevent current flow is required when a battery voltage drops below a given voltage threshold, referred to as an under-voltage lockout. For example, a protection circuit may be employed in the battery pack and/or tool to sense the battery voltage, and if the voltage drops below a given voltage level, the circuit directs turning off of a discharge semiconductor device (e.g., a discharge FET). As a result, battery cells may still be susceptible to charge, but cannot discharge.

Accordingly, conventional battery packs with charge/discharge control and over-discharge protection have been designed primarily for low-voltage portable electronic devices. Such devices are characterized by using battery packs of secondary batteries cells (such as Li-ion, NiCd, NiMH) that provide a maximum output voltage of about 4.2 volts/cell, for example.

However, much higher voltages than described above are required for power electronic devices such as cordless power tools. Accordingly, modified NiCd battery packs that provide the same or greater power at lower weight, and Li-ion battery packs which may provide higher voltage outputs than current Li-ion batteries, and at a much reduced weight (as compared to NiCd or NiMH), are being developed. A characteristic of these battery packs is that both batteries may exhibit substantially lower impedance characteristics than conventional Li-ion, NiCd and NiMH batteries.

However, as these battery technologies advance, the introduction of lower impedance chemistries and construction styles to develop secondary batteries generating substantially higher output voltages (such as at least 11 V and up, for example) may possibly create compatibility issues with existing cordless power tools. Battery packs having lower impedance also means that the pack can supply substantially higher current to an attached electronic component, such as a power tool. As current through a motor of the attached tool increases, demagnetization forces (e.g., the number of armature turns of the motor times the current, ampere-turns) could substantially increase beyond a desired or design limit in the motor. Such undesirable demagnetization could thus potentially burn up the motor.

For example, a lower impedance electrical source could cause damage to a tool's motor when the tool is held at stall condition. During motor stall, the motor and battery impedances are the only mechanisms to limit the current since there is no back-EMF created by the motor. With a lower impedance pack, the currents would be higher. Higher currents through the motor might cause a stronger demagnetization force than what the tool's permanent magnets were designed to withstand. Additionally, start-up of the tool could produce excessive starting currents and cause demagnetization of the motor.

Thermal overload could also be a result of using a low impedance electrical source in an existing power tool, as the new batteries may be designed to run longer and harder than what the original cordless tool system was designed. Accordingly, over-discharge or current limiting controls may need to be in place before these developing lower-impedance batteries may be use with existing cordless power tools, for example.

One current limiting approach has been through the use of diodes in the cordless power tools. A diode is a device that blocks current in one direction while permitting current to flow in another direction. The diodes can be used in a number of ways. For example, an electrical device that uses batteries often contains a diode that protects the device if the batteries are inadvertently inserted backward. The diode simply blocks current from leaving the battery if the polarity is reversed. This may serve as a protector for sensitive electronics in an electrical device such as a cordless tool. However, conventional diodes are generally large, and take up a substantial amount of space in the device. Moreover, conventional diodes are generally placed in a portion or location within the electrical device that may be easily acceptable to damage or malfunction.

The document US 2001/053313 A1 discloses a cordless power tool using batteries as a power source having a diode protecting an electric circuit in case of the batteries being connected with reverse polarity.

US 2005/0221659 A1 discloses an LED light engine including a flexible electrical cable, a wire-socket assembly attached to the cable, and an LED module selectively attached to the wire-socket assembly.

US 2002/0172035 A1 discloses a power tool including a lighting device mounted on a housing, including an electric light connected to a power source circuit via an electric line, at least a portion of which is supported or retained by a wire guide mounted on the housing.

US 6,749,028 B1 discloses a trigger assembly for controlling an electric power tool including a motor, including a flywheel diode for the motor.

EP 0 512 316 A2 discloses a switch for an electric tool having a DC motor, including a freewheeling diode.

According to a first aspect of the invention, there is provided a diode assembly for a wire harness comprising the features of claim 1.

An example embodiment is directed to a diode assembly for a wire harness which includes a printed circuit board (PCB), a diode connected to the PCB, and a plurality of diode lead wires extending from the PCB for external connections. The diode assembly includes a diode wire trap interfacing with the diode, and a heat sink in direct or indirect contact with one or more of the PCB, diode and diode wire trap for dissipating heat.

Example embodiments will become more apparent by describing, in detail, example embodiments thereof with reference to the attached drawings, wherein like procedures are represented by like reference numerals, which are given by way of illustration only and thus do not limit the present invention.

FIG. 1 is a side view of a cordless power tool in accordance with an example embodiment.

FIG. 2 is a front view of a cordless power tool in accordance with an example embodiment.

FIG. 3 is a partial perspective view showing a portion of one half shell of the power tool in accordance with an example embodiment.

FIG. 4 is a perspective view of a wire harness and a switch in accordance with an example embodiment.

FIG. 5 is a perspective view of a wire harness and a switch in accordance with an example embodiment.

FIG. 6 is an exploded perspective view showing the wire harness in accordance with an example embodiment.

FIG. 7 is a connection schematic of the lead wires in accordance with an example embodiment.

FIG. 8 is a perspective view showing lead wires connected to a terminal block in accordance with an example embodiment.

FIG. 9 is a perspective view showing a diode assembly in accordance with an example embodiment.

FIG. 10 is an exploded perspective view showing a diode assembly in accordance with an example embodiment invention.

FIG. 11 is a schematic diagram of a variable speed switch in the OFF position in accordance with an example embodiment.

It should be noted that these figures are intended to illustrate the general characteristics of method and apparatus of example embodiments of this invention, for the purpose of the description of such example embodiments herein. These drawings are not, however, to scale and may not precisely reflect the characteristics of any given embodiment, and should not be interpreted as defining or limiting the range of values or properties of example embodiments within the scope of this invention.

As used herein, power tools may be understood as a cordless power tool with the use of light-weight portable power sources, such as Li-ion battery packs that may provide the commensurate power with its use. Example power tools may include, but are not limited to, drills, high torque impact wrenches, single-handed metal working tools, nailers, hand planers, circular saws, jig saws, variable speed belt sanders, reciprocating saws, two handed drills such as rotary and demolition hammerdrills, routers, cut-off tools, plate joiners, drill presses, table saws, planers, miter saws, metal working tools, chop saws, cut-off machines, bench grinders, etc. Some of these tools may currently be commercially available only in a corded version, but may become cordless. These classifications are not intended to be inclusive of all power tools in which example embodiments of the present invention may be applied, but are only illustrative.

It should further be appreciated by one skilled in the art that the battery pack includes a plurality of battery cells disposed within a battery pack housing. The battery pack may be embodied as at least one of a lithium ion (Li-ion), a nickel cadmium (NiCd), a nickel metal hydride (NiMH) and a lead-acid battery pack, for example, in terms of the chemistry makeup of individual cells, electrodes and electrolyte of the battery pack. The battery cells may be connected in series and/or parallel.

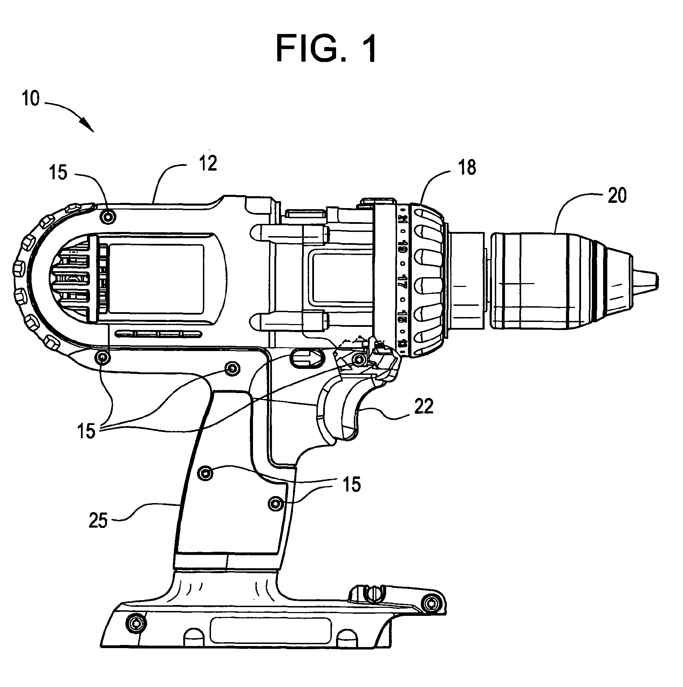

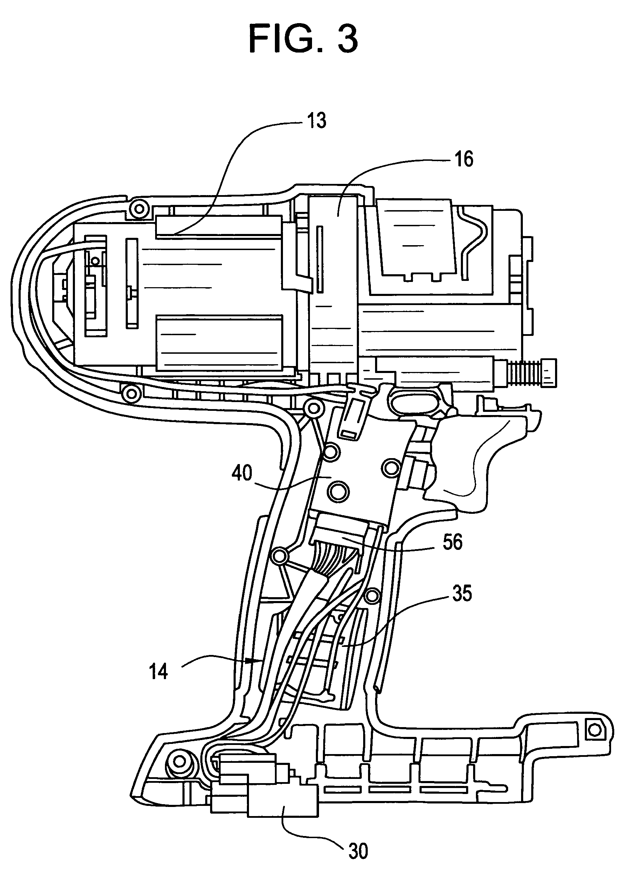

FIG. 1 is a side view of a cordless power tool according to an example embodiment of the present invention. Referring to FIG. 1, an example cordless power tool may be generally indicated by reference numeral 10 which designates a drill, and may include a housing 12, a motor assembly 13 (shown in FIG. 3), a multi-speed transmission assembly 16 (shown in FIG. 3), a clutch mechanism 18, a chuck 20, a trigger assembly 22 and a handle 25. The housing 12 is preferably molded from a suitable plastic material, such as polyethylene, polypropylene, or polyurethane. The housing 12 may be injection molded having two half portions 12A, 12B secured together in a conventional manner using mechanical fasteners, such as screws 15.
It should be understood to those skilled in the art that components of the power tool 10, such as the motor assembly 14, the transmission assembly 16, the chuck 20 and the trigger assembly 22 are conventional in nature and therefore will not be discussed in detail in the present application.

A battery pack (not shown) may be attached to a bottom portion of the power tool 10. The battery pack may be a rechargeable high power Li-ion battery pack comprised of a plurality of Li-ion cells having a Li-metal oxide or Li-metal phosphate cathode as the active material therein, for example. However, it should be appreciated that other battery cells make-up, such as, nickel cadmium (NiCd), nickel metal hydride (NiMH) and lead-acid battery pack, may be employed.

The bottom of the tool 10 contains grooves 27 positioned laterally at side ends (shown in FIG. 3) to facilitate releasable insertion or removal of the battery pack and the tool 10. The grooves 27 are slidably received by cooperating guide rails on the battery pack for facilitating insertion and removal of the battery pack. The groove-rail arrangement is described in detail in co-pending U.S. Patent Application Serial No. 11/553,355, filed October 26, 2006 to Adam Casalena et al., and entitled "BATTERY PACK, CHARGER AND TERMINAL BLOCK ARRANGEMENTS FOR CORDLESS POWER TOOL SYSTEM".

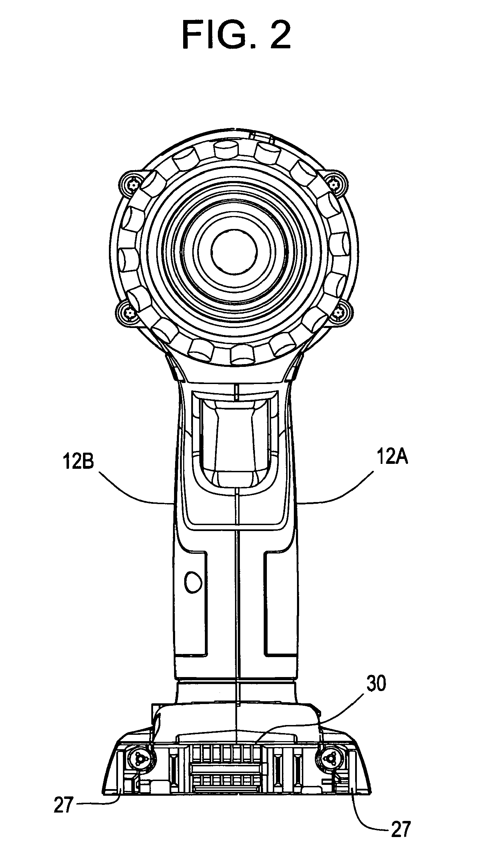

Referring to FIG. 2, a tool terminal block 30 is shown, positioned near the bottom of the tool 10. The terminal block 30 provides the logic and power terminals connections between the tool 10 and the battery pack. In other words, the terminal block 30 provides the electrical interconnections between the tool and the battery pack. The logic terminal in the terminal block 30 may have a plurality of contacts to matingly interface with contacts on a terminal block (not shown) of the battery pack.

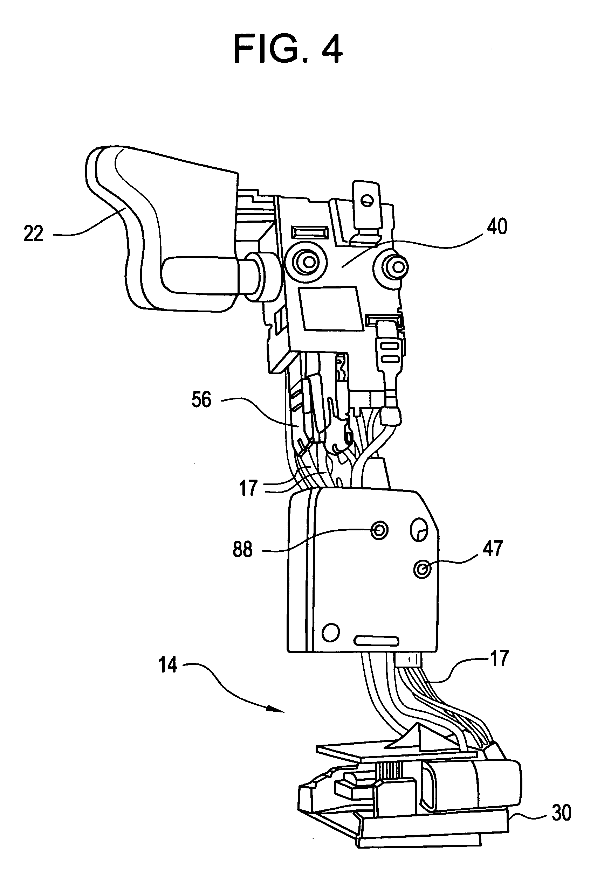

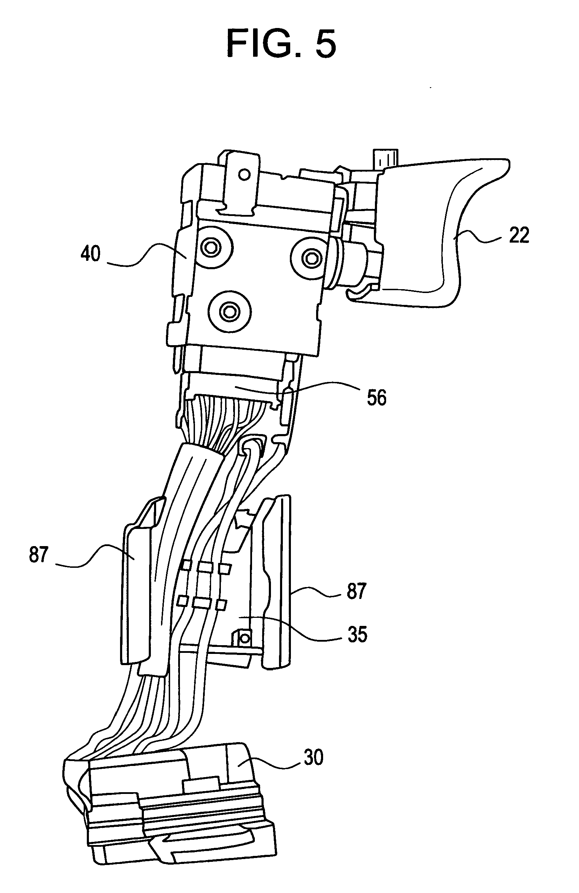

FIGS. 4 and 5 are perspective views of a wire harness 14 and a switch 40 in accordance with an example embodiment. The wire harness 14 and switch 40 are integrated in the handle 25 section of the tool 10.

Referring to FIG. 4, a trigger 22 is connected to a trigger switch 40, and the switch 40 is connected to a terminal block 30 via lead wires 17 of the harness 14. It should be appreciated that the switch 40 may have a potentiometer (not shown) to vary the speed of the tool motor. A switch terminal block 56 is attached to switch 40 for electrical communication with the terminal block 30 in the battery pack. The battery pack terminal block is described in detail in the co-pending '355 application to Casalena et al. above.

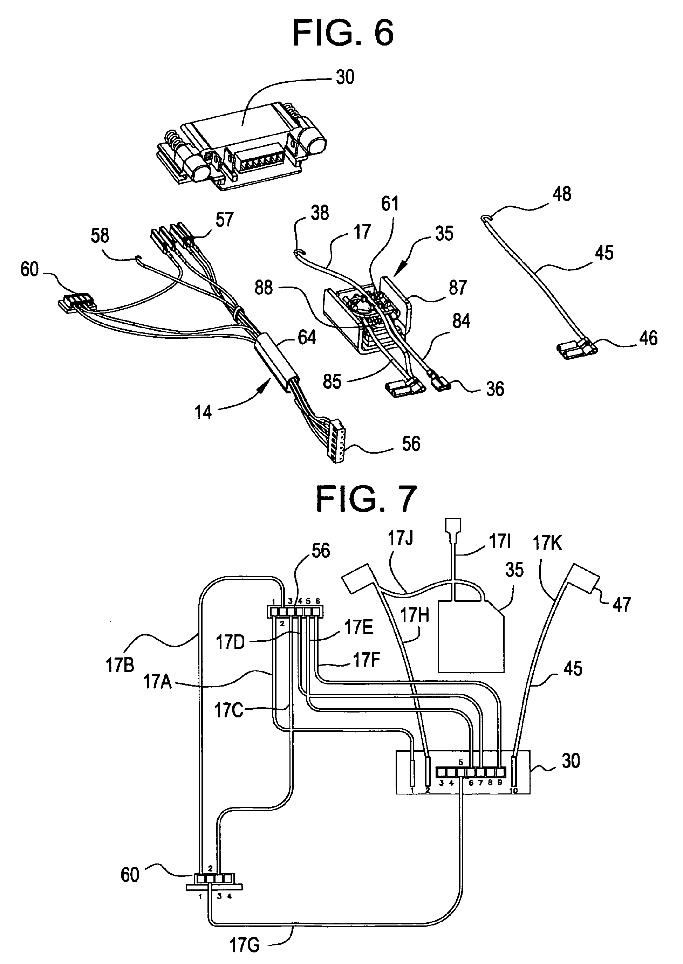

As best shown in FIG. 7, a sensor tag 47 is generally adhered to an inside surface (not shown) of the tool housing 12 of the cordless power tool 10. The sensor tag 47 is made from any conventional composite metal materials. The composite metal material may provide a detecting means for signaling a detector (e.g., magnetic sensor detector) to be activated in order to prevent theft.

FIG. 6 is an exploded perspective view showing the wire harness in separate configuration. Referring to FIG. 6, a wire harness assembly 14, a diode assembly 35, and a tool motor lead wire 45 for connecting to the motor of tool 10 are shown. The wire harness assembly 14 includes the switch terminal block 56, a printed circuit board (PCB) connector assembly 60, and the lead wires 17 for connecting the switch terminal block 56 to the PCB connector assembly 60 and the terminal block 30. The lead wires 17 may be surrounded with an insulating tubular member 64 to neatly encase the lead wires 17.

Although not shown, the PCB connector assembly 60 includes a plurality of surface mount technology (SMT) ID resistors. Use of SMT resistors allows flexibility in designing other components within the tool 10, and reduces the dimensions and size of the tool 10. The ID resistor is described in detail in co-pending U.S. Patent Application Serial No. (Unassigned, Atty. Dkt. No. 0275A-001146/US), to the inventor, filed October 27, 2006 and entitled "REMOTE ID RESISTOR ASSEMBLY FOR WIRE HARNESS".

The wire harness assembly 14 further includes a diode assembly 35 which is described in more detail later. A single lead wire 17 is attached to a top surface of the diode assembly 35. As shown in FIG. 6, the lead wire 17 contains a board-in connector 36 at one end for electrical connection to other components. A J-shaped wire end 38 forms the other end of lead wire 17.

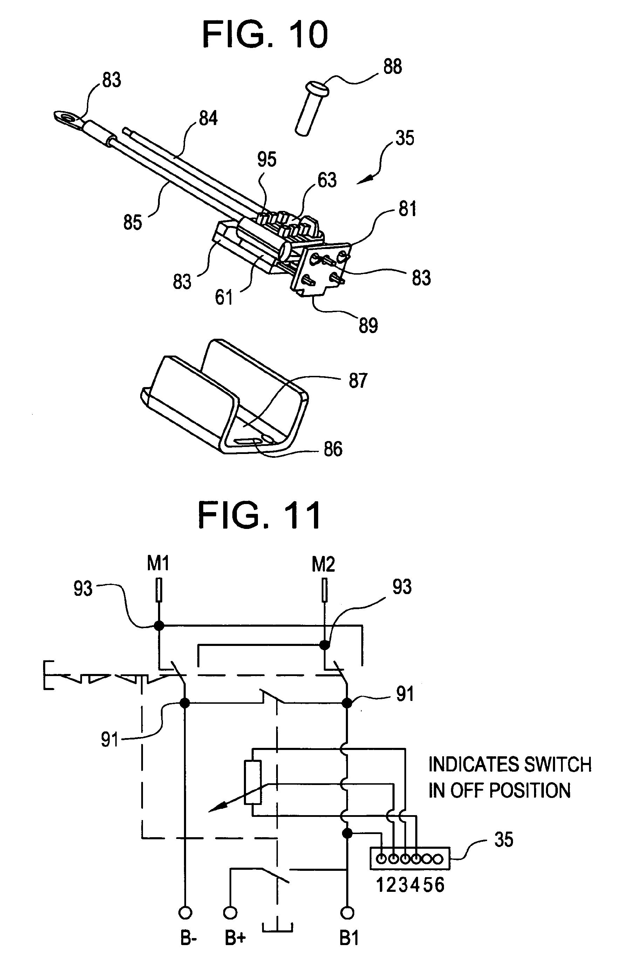

Referring to FIGS. 6 and 10, one end of each of the lead wires 17 includes a terminal connector 57 for insertion into a logic terminal 31 in the backside of the terminal block 30. The terminal connectors 57 may be, for example, right-angle board-in connectors. Board-in connectors 57 provide easy of insertion and good retention once inserted into corresponding terminal connections within logic terminal 31. The other ends of the lead wires 17 may also include terminal connectors (not shown) inserted in the terminals of the switch terminal block 56.

FIG. 7 is a connection schematic for lead wires 17 in accordance with an example embodiment. Referring to FIG. 7, the terminal block 30 includes terminals 1-10, the switch terminal block 56 includes terminals 1-6, and the PCB connector 60 includes terminals 1-4. The connection of the lead wires 17A-17K are illustrated as the following: wire 17A connects terminal 1 of the switch terminal block 56 to terminal 1 of terminal block 30, wire 17B connects terminal 2 of the switch terminal block 56 to terminal 1 of the PCB connector 60, wire 17C connects terminal 3 of the switch terminal block 56 to terminal 3 of PCB connector 60, wire 17D connects terminal 4 of the switch terminal block 56 to terminal 7 of terminal block 30, wire 17E connects terminal 5 of the switch terminal block 56 to terminal 6 of terminal block 30, wire 17F connects terminal 6 of the switch terminal block 56 to terminal 9 of terminal block 30, and wire 17G connects terminal 5 of the terminal block 30 to terminal 2 of the PCB connector 60. Wire 17H is connected to terminal 2 of the terminal block 30 and wire 17K is connected to terminal 10 of the terminal block 30. Wires 17I and 17J extend from the diode assembly 35. It should be appreciated that other connection scheme may be employed besides the one described above.

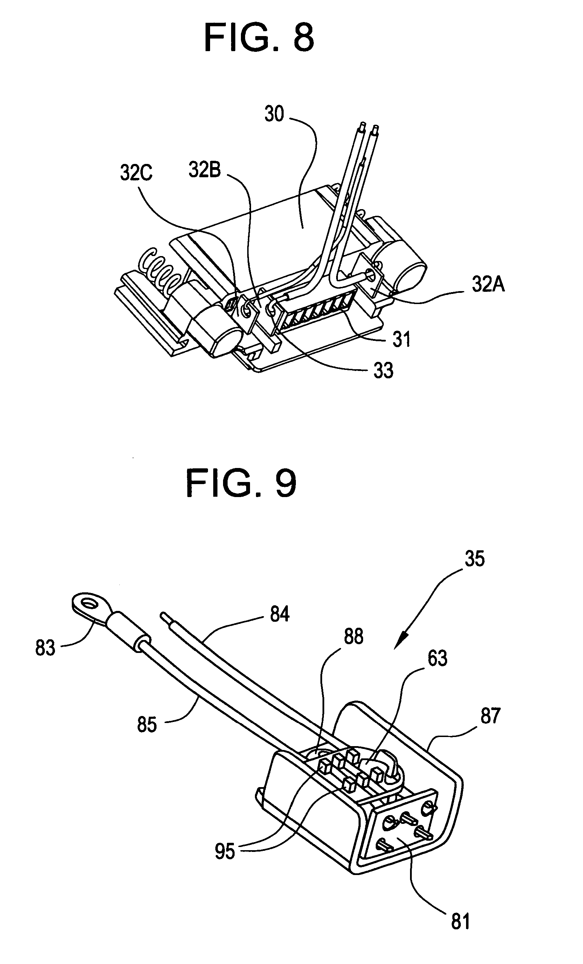

FIG. 8 is a perspective view showing wires connected to a backside of the terminal block in accordance with an example embodiment. Referring to FIG. 8, the backside of the terminal block 30 includes a logic terminal 31 with a plurality of contact terminals and a plurality of blade terminals 32. The blade terminals 32 represent power terminals of the power tool 10 for receiving corresponding power terminals of the battery pack terminal block to power tool 10. As an example embodiment, there are two blade terminals 32B, 32C at one side of logic terminal 31 and one blade terminal 32A at the other side of logic terminal 31.

Referring back to FIG. 6, ends 38, 48, 58 of lead wires 17 and 45 have a general J-shape. The J-shaped ends 38, 48, 58 are inserted into their respective holes 33 located in blade terminals 32A, 32B, 32C so as to provide a secure connection. Once the ends of the lead wires 38, 48, 58 are inserted into the respective hole 33, the ends 38, 48, 58 may be soldered (such as with a lead-free solder) onto the blade terminals 32A, 32B, 32C.

FIGS. 9 and 10 illustrate a diode assembly 35 in accordance with an example embodiment. Referring to FIGS. 9 and 10, the diode assembly 35 includes a diode 61, a diode wire trap 63, a printed circuit board (PCB) 81, a heat sink 87, and a plurality of diode lead wires 84, 85 extending from the PCB 81. The heat sink 87 is in direct or indirect contact with one or more of the PCB 81, diode 61 and diode wire trap 63 for dissipating heat, as described in further detail below.

The diode 61 may be attached to the PCB 81 by a solder, for example. Due to the vertical mounting of the PCB 81, soldering of the diode lead wires 84, 85 to the PCB 81 may be easily performed. However, it should be appreciated that other attachment means may be employed to attach the diode 61 to the PCB 81. The diode wire trap 63 may be made from a plastic composite material; however the diode wire trap 63 may be fabricated from materials other than a plastic composite.

The diode 61 and diode wire trap 63 are attached to the heat sink 87 by a fastener 88 such as a riv-screw. However, it should be appreciated by one skilled in the art that other fastening means may be employed. The riv-screw 88 extends through a hole (not shown) in the diode 61 and eventually screws into a corresponding hole (not shown) in the heat sink 87. The riv-screw 88 secures the diode wire trap 63, diode 61 to the heat sink 87.

The diode wire trap 63 interfaces with the top surface topography of the diode 61 via protrusions (not shown for clarity) extending from the bottom surface of the diode wire trap 63. The riv screw 88 clamps through the diode wire trap 63 and diode 61 to the heat sink 87. The diode lead wires 84, 85, which extend from the PCB 81, are secured in the diode wire trap 63 via grooves (not shown for clarity) on an interior surface of the diode wire trap 63. The diode lead wires 84, 85 are vertically restrained within the grooves by an additional element (not shown) of the diode wire trap 63 which "wraps" overtop of the grooves and is secured by a locking element (not shown) that is integral to the diode wire trap 63.

A terminal connector 83 such as a board-in connector is formed at one end of lead wire 85 for connection to various components in the tool 10 such as terminals of the trigger switch 40 across the leads of the tool motor. The diode wire trap 63 further includes a plurality of connectors 95 disposed on a top surface of the diode wire trap 63 for receiving the lead wires 17 (as shown in FIG. 6). The connectors 95 secure the lead wires 17 to the diode wire trap 63.

In one example, the heat sink 87 may have a general U-shape to surround the diode 61 and transfer heat generated from the diode 61. However, the shape of heat sink 87 may be other than U-shaped, such as flat, curved, etc. The heat sink 87 may also include projecting portions such as fins (not shown) to more effectively move heat towards the projecting portions of the heat sink 87. The heat sink 87 can be made from metal such as aluminum, copper, brass or any material that provides the necessary heat sinking effect for the diode 61.

It should be appreciated that the heat sink 87 may be any type of metallic sink with or without projecting portions, formed of a metallic or an electrically nonconductive conductive material. Examples include but are not limited to potting compounds, gels and/or greases to extract the heat.

Referring to FIG. 10, the diode 61 is connected to the PCB 81. This allows anodes of the diode 61 to be connected on the PCB 81 so as to eliminate any additional connections. Moreover, the vertically mounted PCB 81 allows the use of conventional through-hole techniques for connecting the diode lead wires 84, 85 to the PCB 81.

The PCB 81 includes a tab member 89 near the bottom of the PCB 81. The tab member 89 permits a vertical mounting of the PCB 81 on the heat sink 87. The tab member 89 is inserted into a slot member 86 in the heat sink 87. The slot member 86 provides additional mechanical support for the PCB 81 (e.g., resisting damage from handling and/or reducing tool vibration).

FIG. 11 is a schematic diagram of a variable speed switch in the OFF position in accordance with an example embodiment. Referring to FIG. 11, the diode 61 may be connected to terminals of a switch 91, which given the switch's internal schematic, places the diode 61 across leads 93 of a motor M1 and M2. This illustrates a schematic of a variable speed switch. The diode 61 may be connected to B1 and B+ (e.g., diode cathode may be connected to B1 (wire 17J in FIG. 1) and diode anode to B- (wire 17I in FIG. 7). It should be appreciated that the switch design may be different for non-variable speed tools, but it may achieve the same result.

The example embodiments of the present invention being thus described, it will be obvious that the same may be varied in many ways, without departure from the scope of the invention as defined by the appended claims.

## Claims

1. A diode assembly comprised in a wire harness (14) configured within a handle section (25) of a cordless power tool (10), the cordless power tool (10) using batteries as a power source, having a diode (61) for protecting the power tool (10) in case of connection of the batteries with reverse polarity,
the diode assembly (35) comprising:
a printed circuit board (81) the diode (61) being connected to the printed circuit board (81);
a plurality of diode lead wires (84, 85) extending from the printed circuit board (81) for external connections;
a diode wire trap (63) interfacing with a top surface of the diode (61) and with the diode lead wires (84, 85); and
a heat sink (87) in direct or indirect contact with one or more of the printed circuit board (81), diode (61) and diode wire trap (63) for dissipating heat.

2. The diode assembly (35) according to claim 1, wherein the printed circuit board (81) is perpendicularly disposed in relation to the diode (61).

3. The diode assembly (35) according to claim 1, wherein the printed circuit board (81) includes a plurality of openings for receiving ends of the plurality of diode lead wires (84, 85) which extend through the openings.

4. The diode assembly (35) according to claim 1, wherein the plurality of diode leads wires (84, 85) are attached to the printed circuit board (81) by a solder.

5. The diode assembly (35) according to claim 1, wherein the diode (61) is attached to the printed circuit board (81) by a solder.

6. The diode assembly (35) according to claim 1, wherein the diode wire trap (63) includes one or more grooves within an interior surface thereof for securing the diode lead wires (84, 85) to the diode wire trap (63).

7. The diode assembly (35) according to claim 1, wherein the diode wire trap (63) includes a plurality of connectors (95) for securing further lead wires (17) to the diode wire trap (63).

8. The diode assembly (35) according to claim 7, wherein the connectors (95) are disposed on a top surface of the diode wire trap (63).

9. The diode assembly (35) according to claim 1, wherein diode wire trap (63) is made from a plastic material.

10. The diode assembly (35) according to claim 1, wherein the printed circuit board (81) includes a tab member (89) to be inserted into a slot opening (86) disposed on the heat sink (87).

11. The diode assembly (35) according to claim 10, wherein the tab member (89) is located near a bottom of the printed circuit board (81).

12. The diode assembly (35) according to claim 1, wherein the diode wire trap (63) is attached to the heat sink (87) by a fastener (88).

13. The diode assembly (35) according to claim 12, wherein the fastener (88) is a riv-screw (88).

14. The diode assembly (35) according to claim 1, wherein the heat sink (87) is made from at least one of aluminum, copper and brass.

## Patentansprüche

1. Diodenanordnung, die in einem Kabelstrang (14) untergebracht ist, der in einem Griffabschnitt (25) eines kabellosen Elektrowerkzeuges (10) eingebaut ist, wobei das kabellose Elektrowerkzeug (10) Batterien als Stromquelle verwendet, mit einer Diode (61) zum Schutz des Elektrowerkzeuges (10) im Fall eines Anschlusses der Batterien mit umgekehrter Polarität,
wobei die Diodenanordnung (35) Folgendes umfasst:
eine Leiterplatte (81), wobei die Diode (61) an die Leiterplatte (81) angeschlossen ist;
mehrere Diodenanschlussdrähte (84, 85), die sich von der Leiterplatte (81) für externe Anschlüsse erstrecken;
eine Diodendraht-Haftstelle (63), die mit einer oberen Fläche der Diode (61) und mit den Diodenanschlussdrähten (84, 85) verbunden ist; und
einen Wärmeableiter (87) in direktem oder indirektem Kontakt mit einem oder mehreren aus Leiterplatte (81), Diode (61) und Diodendraht-Haftstelle (63) zum Abführen von Wärme.

2. Diodenanordnung (35) nach Anspruch 1, wobei die Leiterplatte (81) in Bezug auf die Diode (61) senkrecht angeordnet ist.

3. Diodenanordnung (35) nach Anspruch 1, wobei die Leiterplatte (81) mehrere Öffnungen zur Aufnahme von Enden der mehreren Diodenanschlussdrähte (84, 85) umfasst, die sich durch die Öffnungen hindurch erstrecken.

4. Diodenanordnung (35) nach Anspruch 1, wobei die mehreren Diodenanschlussdrähte (84, 85) an der Leiterplatte (81) mit Hilfe eines Lötmittels befestigt sind.

5. Diodenanordnung (35) nach Anspruch 1, wobei die Diode (61) an der Leiterplatte (81) mit Hilfe eines Lötmittels befestigt ist.

6. Diodenanordnung (35) nach Anspruch 1, wobei die Diodendraht-Haftstelle (63) eine oder mehrere Rillen in einer inneren Fläche zum Fixieren der Diodenanschlussdrähte (84, 85) an der Diodendraht-Haftstelle (63) umfasst.

7. Diodenanordnung (35) nach Anspruch 1, wobei die Diodendraht-Haftstelle (63) mehrere Anschlussklemmen (95) zum Fixieren weiterer Anschlussdrähte (17) an der Diodendraht-Haftstelle (63) umfasst.

8. Diodenanordnung (35) nach Anspruch 7, wobei die Anschlussklemmen (95) auf einer oberen Fläche der Diodendraht-Haftstelle (63) angeordnet sind.

9. Diodenanordnung (35) nach Anspruch 1, wobei die Diodendraht-Haftstelle (63) aus einem Kunststoffmaterial hergestellt ist.

10. Diodenanordnung (35) nach Anspruch 1, wobei die Leiterplatte (81) ein Laschenelement (89) umfasst, das in eine schlitzförmige Öffnung (86), die am Wäremableiter (87) angeordnet ist, eingefügt wird.

11. Diodenanordnung (35) nach Anspruch 10, wobei sich das Laschenelement (89) nahe eines Bodens der Leiterplatte (81) befindet.

12. Diodenanordnung (35) nach Anspruch 1, wobei die Diodendraht-Haftstelle (63) am Wärmeableiter (87) mittels eines Befestigungselementes (88) befestigt ist.

13. Diodenanordnung (35) nach Anspruch 12, wobei das Befestigungselement (88) eine Magazin-Blindniete (88) ist.

14. Diodenanordnung (35) nach Anspruch 1, wobei der Wärmeableiter (87) aus mindestens einem aus Aluminium, Kupfer und Messing hergestellt ist.

## Revendications

1. Ensemble diode compris dans un faisceau électrique (14) configuré à l'intérieur d'une section poignée (25) d'un outil électrique sans fil (10), l'outil électrique sans fil (10) utilisant des batteries en tant que source d'alimentation électrique, possédant une diode (61) pour protéger l'outil électrique (10) en cas de connexion des batteries avec une polarité inverse,
l'ensemble diode (35) comprenant :
une carte de circuit imprimé (81), la diode (61) étant connectée à la carte de circuit imprimé (81) ;
une pluralité de fils conducteurs de diode (84, 85) s'étendant à partir de la carte de circuit imprimé (81) pour des connexions externes ;
une bride-fil de diode (63) réalisant une interface avec une surface supérieure de la diode (61) et avec les fils conducteurs de diode (84, 85) ; et
un dissipateur de chaleur (87) en contact direct ou indirect avec un ou plusieurs éléments parmi la carte de circuit imprimé (81), la diode (61) et la bride-fil de diode (63) pour dissiper de la chaleur.

2. Ensemble diode (35) selon la revendication 1, dans lequel la carte de circuit imprimé (81) est disposée perpendiculairement par rapport à la diode (61).

3. Ensemble diode (35) selon la revendication 1, dans lequel la carte de circuit imprimé (81) comprend une pluralité d'ouvertures pour recevoir des extrémités de la pluralité de fils conducteurs de diode (84, 85) qui s'étendent à travers les ouvertures.

4. Ensemble diode (35) selon la revendication 1, dans lequel la pluralité de fils conducteurs de diode (84, 85) sont attachés à la carte de circuit imprimé (81) par une brasure tendre.

5. Ensemble diode (35) selon la revendication 1, dans lequel la diode (61) est attachée à la carte de circuit imprimé (81) par une brasure tendre.

6. Ensemble diode (35) selon la revendication 1, dans lequel la bride-fil de diode (63) comprend une ou plusieurs rainures à l'intérieur d'une surface intérieure de celle-ci pour fixer les fils conducteurs de diode (84, 85) à la bride-fil de diode (63).

7. Ensemble diode (35) selon la revendication 1, dans lequel la bride-fil de diode (63) comprend une pluralité de connecteurs (95) pour fixer des fils conducteurs supplémentaires (17) à la bride-fil de diode (63).

8. Ensemble diode (35) selon la revendication 7, dans lequel les connecteurs (95) sont disposés sur une surface supérieure de la bride-fil de diode (63).

9. Ensemble diode (35) selon la revendication 1, dans lequel la bride-fil de diode (63) est faite d'une matière plastique.

10. Ensemble diode (35) selon la revendication 1, dans lequel la carte de circuit imprimé (81) comprend un élément languette (89) à insérer dans une ouverture en fente (86) disposée sur le dissipateur de chaleur (87).

11. Ensemble diode (35) selon la revendication 10, dans lequel l'élément languette (89) est situé près d'un fond de la carte de circuit imprimé (81).

12. Ensemble diode (35) selon la revendication 1, dans lequel la bride-fil de diode (63) est attachée au dissipateur de chaleur (87) par un élément de fixation (88).

13. Ensemble diode (35) selon la revendication 12, dans lequel l'élément de fixation (88) est un rivet fileté « Rivscrew » (88).

14. Ensemble diode (35) selon la revendication 1, dans lequel le dissipateur de chaleur (87) est fait d'au moins un élément parmi de l'aluminium, du cuivre et du laiton.
